# EUROPEAN PATENT APPLICATION

(11) **EP 4 242 927 A1**
(43) Date of publication of application: **13.09.2023**
(21) Application number: 23158042.4
(22) Date of filing: 22.02.2023
(51) Int. Cl.: G06N 3/065, G11C 11/16, G11C 11/54, G06N 3/048, G06N 3/08

(54) **SYSTEMS AND METHODS FOR A STORAGE BIT IN AN ARTIFICIAL NEURAL NETWORK**

(30) Priority: 07.03.2022 US 202263268953 P; 23.08.2022 US 202217893462
(71) Applicant: Everspin Technologies, Inc., Chandler, AZ 85226 (US)
(72) Inventor: ALAM, Syed M., Austin (US); HOUSSAMEDDINE, Dimitri, Sunnyvale (US); AGGARWAL, Sanjeev, Scottsdale (US)
(74) Representative: Eisenführ Speiser

(57) **Abstract**

The present disclosure is drawn to, among other things, a device comprising input circuitry; weight operation circuitry electrically connected to the input circuitry; bias operation circuitry electrically connected to the weight operation circuitry; storage circuitry electrically connected to the weight operation circuitry and the bias operation circuitry; and activation function circuitry electrically connected to the bias operation circuitry, wherein at least the weight operation circuitry, the bias operation circuitry, and the storage circuitry are located on a same chip.

## Description

### CROSS-REFERENCE TO RELATED APPLICATION

This application claims benefit to U.S. Provisional Patent Application No. 63/268,953, filed March 7, 2022, the entire contents of which are incorporated herein by reference.

### TECHNICAL FIELD

Embodiments of the present disclosure relate to, among other things, a storage bit. More specifically, certain embodiments of the present disclosure relate to a storage bit in an artificial neural network.

### INTRODUCTION

An artificial neural network may have an input layer and an output layer with multiple hidden layers. Each layer following the input layer may have multiple hardware neurons that perform various operations. For example, each hardware neuron may perform multiplication and accumulation (MAC) operations with respect to inputs and weight values, summation of the product of the MAC operations with any bias values, and/or performance of an activation function, such as a rectified linear unit (ReLU) activation function or a sigmoid function for producing an output value to the output layer.

For some conventional hardware neurons, weight values and bias values may require storage operations, retrieval operations, and/or modification operations in these artificial neural network contexts. For example, in an inference application, weight values and bias values for each hardware neuron may need to be stored in non-volatile memory off of the chip. During use of the hardware neuron, the weight values and bias values may be loaded from the off-chip non-volatile memory into on-chip random access memory (RAM) registers where the artificial neural network may be implemented. Off-chip memory access for weight values and bias values may add significant power consumption to the chip and/or increase latency in operations of the hardware neuron. Therefore, there may be a need for a configuration of a hardware neuron that reduces power consumption and latency typically associated with loading these values from non-volatile memory into a hardware neuron.

### BRIEF DESCRIPTION OF THE DRAWINGS

In the course of the detailed description that follows, reference will be made to the appended drawings. The drawings show different aspects of the present disclosure and, where appropriate, reference numerals illustrating like structures, components, materials, and/or elements in different figures are labeled similarly. It is understood that various combinations of the structures, components, and/or elements, other than those specifically shown, are contemplated and are within the scope of the present disclosure.

Moreover, there are many embodiments of the present disclosure described and illustrated herein. The present disclosure is neither limited to any single aspect nor embodiment thereof, nor to any combinations and/or permutations of such aspects and/or embodiments. Moreover, each of the aspects of the present disclosure, and/or embodiments thereof, may be employed alone or in combination with one or more of the other aspects of the present disclosure and/or embodiments thereof. For the sake of brevity, certain permutations and combinations are not discussed and/or illustrated separately herein; however, all permutations and combinations are considered to fall within the scope of the present inventions.
FIG. 1 depicts a functional diagram of an exemplary artificial neural network, according to an exemplary embodiment of the present disclosure.
FIG. 2 depicts an example of a first hardware neuron of the artificial neural network of FIG. 1, according to an exemplary embodiment of the present disclosure.
FIG. 3 depicts an example of a second hardware neuron of the artificial neural network of FIG. 1, according to an exemplary embodiment of the present disclosure.
FIG. 4 depicts a configuration of exemplary storage circuitry of a hardware neuron, according to an exemplary embodiment of the present disclosure.
FIG. 5 depicts various bridge element configurations of storage circuitry of a hardware neuron, according to an exemplary embodiment of the present disclosure.
FIG. 6A depicts an example of circuitry of a multi-time programmable storage circuitry, of a hardware neuron, configured for writing of a first value, according to an exemplary embodiment of the disclosure.
FIG. 6B depicts an example of circuitry of a multi-time programmable storage circuitry, of a hardware neuron, configured for writing of a second value, according to an exemplary embodiment of the disclosure.
FIG. 7A depicts an example of circuitry of a one-time programmable storage circuitry, of a hardware neuron, configured for read-out of a first value, according to an exemplary embodiment of the disclosure.
FIG. 7B depicts an example of circuitry of a one-time programmable storage circuitry, of a hardware neuron, configured for read-out of a second value, according to an exemplary embodiment of the disclosure.
FIG. 8A depicts an exemplary one-time programming of storage circuitry of a storage bit with a first value, according to an exemplary embodiment of the disclosure.
FIG. 8B depicts an exemplary one-time programming of storage circuitry of a storage bit with a second value, according to an exemplary embodiment of the disclosure.
FIG. 9 depicts an example configuration of storage circuitry of a hardware neuron, according to an exemplary embodiment of the present disclosure.
FIG. 10 depicts a flowchart for an exemplary method for operation of a hardware neuron, according to an aspect of the present disclosure.

Again, there are many embodiments described and illustrated herein. The present disclosure is neither limited to any single aspect nor embodiment thereof, nor to any combinations and/or permutations of such aspects and/or embodiments. Each of the aspects of the present disclosure, and/or embodiments thereof, may be employed alone or in combination with one or more of the other aspects of the present disclosure and/or embodiments thereof. For the sake of brevity, many of those combinations and permutations are not discussed separately herein.

As used herein, the terms "comprises," "comprising," or any other variation thereof, are intended to cover a non-exclusive inclusion, such that a process, method, article, or apparatus that comprises a list of elements does not include only those elements, but may include other elements not expressly listed or inherent to such process, method, article, or apparatus. The term "exemplary" is used in the sense of "example," rather than "ideal."

### DETAILED DESCRIPTION

Detailed illustrative aspects are disclosed herein. However, specific structural and functional details disclosed herein are merely representative for purposes of describing example embodiments of the present disclosure. The present disclosure may be embodied in many alternate forms and should not be construed as limited to only the embodiments set forth herein. Further, the terminology used herein is for the purpose of describing particular embodiments only and is not intended to be limiting of exemplary embodiments described herein.

When the specification makes reference to "one embodiment" or to "an embodiment," it is intended to mean that a particular feature, structure, characteristic, or function described in connection with the embodiment being discussed is included in at least one contemplated embodiment of the present disclosure. Thus, the appearance of the phrases, "in one embodiment" or "in an embodiment," in different places in the specification does not constitute a plurality of references to a single embodiment of the present disclosure.

As used herein, the singular forms "a," "an," and "the" are intended to include the plural forms as well, unless the context clearly indicates otherwise. It also should be noted that in some alternative implementations, the features and/or steps described may occur out of the order depicted in the figures or discussed herein. For example, two steps or figures shown in succession may instead be executed substantially concurrently or may sometimes be executed in the reverse order, depending upon the functionality/acts involved. In some aspects, one or more described features or steps may be omitted altogether, or may be performed with an intermediate step therebetween, without departing from the scope of the embodiments described herein, depending upon the functionality/acts involved.

Further, the terms "first," "second," and the like, herein do not denote any order, quantity, or importance, but rather are used to distinguish one element from another. Similarly, terms of relative orientation, such as "top," "bottom," etc. are used with reference to the orientation of the structure illustrated in the figures being described. It should also be noted that all numeric values disclosed herein may have a variation of ±10% (unless a different variation is specified) from the disclosed numeric value. Further, all relative terms such as "about," "substantially," "approximately," etc. are used to indicate a possible variation of ±10% (unless noted otherwise or another variation is specified).

In one aspect, the present disclosure is directed to techniques and implementations to program storage devices, including, e.g., non-volatile or "permanent" memory capable of maintaining data when a power supply is deactivated (e.g., Flash, MRAMs, or ReRAMs). Though the description below makes reference to MRAMs or ReRAMs memory device cell, the inventions may be implemented in other memory devices including, but not limited to, electrically erasable programmable read-only memory (EEPROM), and/or ferroelectric random-access memory (FRAM).

The present disclosure relates to systems and methods for a storage bit in an artificial neural network, which may solve one or more of the problems described above. For example, according to certain embodiments, artificial neural network components (e.g., related to weight values, bias values, processing layers, etc.) may be stored using distributed magnetoresistive random-access memory (MRAM) bits. In such an edge distributed memory network, one or more MRAM bits may be physically proximate to one or more hardware neurons or hardware of an artificial neural network (e.g., within 500 microns (um) of each hardware neuron or within 500um of the functional hardware blocks within a hardware neuron), and may be used to store artificial neural network components for that hardware neuron. One or more different MRAM bits may be physically proximate to one or more other hardware neurons of the same artificial neural network, and the different MRAM bits may be used to store artificial neural network components for that other hardware neuron.

As described elsewhere herein, an artificial neural network may include an input layer and an output layer. The input layer may receive one or more inputs to the artificial neural network. The inputs provided via the input layer may be applied to one or more hidden layers comprising hardware neurons. The one or more hidden layers may be trained based on supervised, semi-supervised, or unsupervised machine learning. Each neuron may have multiple components (e.g., weights, biases, layers, etc.) stored in memory. During a training process to train the artificial neural network, the components of the one or more hardware neurons may be accessed, modified, deleted, re-written, added, and/or the like. Accordingly, a large amount of memory access may be required during an artificial neural network training process. Additionally, during a production use of a trained artificial neural network, components of hardware neurons may be accessed, and/or applied, via respective memory access. Additionally, an artificial neural network may continue training during a production process (e.g., based on feedback). Accordingly, components of hardware neurons may be modified, deleted, and/or added during a production process. In inference application of artificial neural networks, multiple components (e.g., weights or biases) of each neuron may have to be stored in non-volatile memory. Conventionally, this is done by storing the weights or biases in Flash memory. Data from external Flash memory may be loaded into artificial neural network processors prior to inference application and stored in locally available volatile storage elements, such as SRAM, scan chain, or registers. Additional power consumption of moving data and storage elements may be needed in this conventional approach.

In this way, one or more of the problems described above may be solved by certain embodiments described herein. For example, power consumption, computational resources, and/or time may be reduced based on the distributed storage (e.g., MRAM) architecture disclosed herein. Continuing with the previous example, certain embodiments disclosed herein may mitigate power consumption, computational resources, and/or latency by providing on-chip access (e.g., instead of off-chip access) to the artificial neural network components (e.g., weight values, bias values, processing layers, etc.). In addition, by having on-chip access, certain embodiments may reduce the amount of routing needed to provide values from storage to processing circuitry, which may conserve chip space, reduce or eliminate circuitry from the artificial neural network, etc.

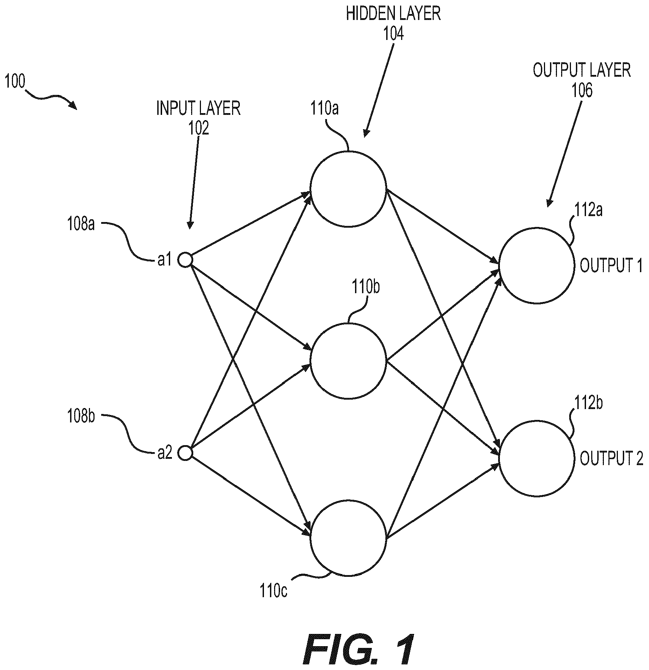

With reference now to FIG. 1, there is depicted a functional diagram of an exemplary artificial neural network 100, according to an exemplary embodiment of the present disclosure. As illustrated, the artificial neural network 100 may include an input layer 102, a hidden layer 104, and an output layer 106. The input layer 102 may provide input values 108 to the hidden layer 104, which may process the input values 108. The hidden layer 104 may include one or more hardware neurons 110 (also referred to herein as neuron devices) for performing the processing, and the hidden layer 104 may provide a result of the processing to the output layer 106 (e.g., to hardware neurons 112 of the output layer 106) for output to a user, for further processing, and/or the like.

As described in more detail herein, weight values and bias values may be stored in non-volatile memory and may be used during operations of the artificial neural network 100. For example, weight values may be associated with each arc (or synapse) between the input layer 102 and the hidden layer 104 and between the hidden layer 104 and the output layer 106. The arcs are illustrated in FIG. 1 as arrows between those layers. Additionally, or alternatively, bias values may be associated with each hardware neuron 110, 112 in the artificial neural network 100.

Although certain embodiments may be described herein in the context of an artificial neural network 100, certain embodiments may be applicable to feedforward neural networks, radial basis function neural networks, Kohonen self-organizing neural networks, recurrent neural networks (RNNs), convolutional neural networks (CNNs), modular neural networks (MNNs), and/or the like.

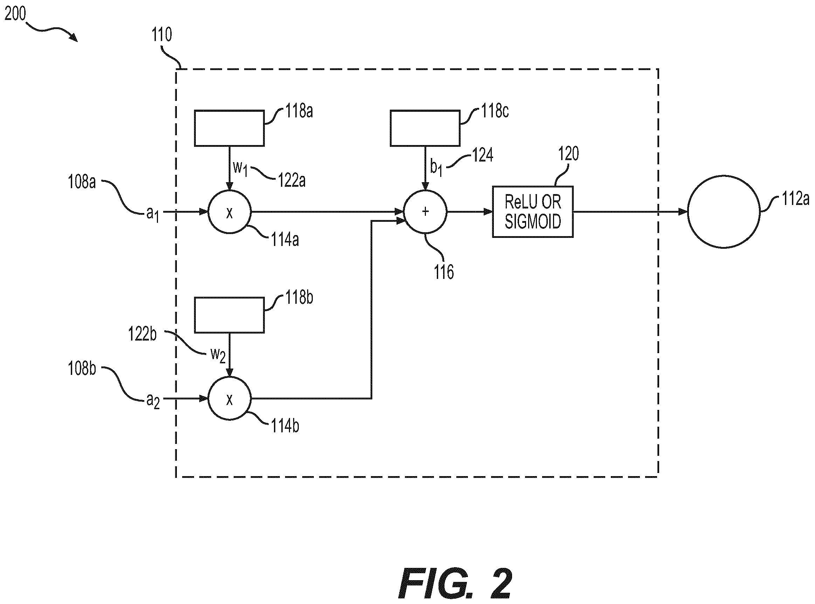

FIG. 2 depicts an example 200 of a first hardware neuron 110 of the artificial neural network 100 of FIG. 1, according to an exemplary embodiment of the present disclosure. For example, FIG. 2 depicts a functional diagram of a hardware neuron 110 of the artificial neural network 100 of FIG. 1; however, certain embodiments may apply equally to a hardware neuron 112.

As illustrated, the hardware neuron 110 may include weight operation circuitry 114, which may be configured to perform an operation on an input value 108, such as a multiplier operation. For example, the multiplier operation may include multiplying input values 108 received at the hardware neuron 110 by one or more weight values 122 associated with the hardware neuron 110. The weight values 122 may be stored in storage circuitry 118 proximate to the hardware neuron 110 and/or the weight operation circuitry 114. The weight operation circuitry 114 may read the weight values 122 from the storage circuitry 118 and may multiply one or more input values 108 by the weight values 122. The weight operation circuitry 114 may multiply the input values 108 by the weight values using multiplier circuitry. As a specific example, the weight operation circuitry 114 may multiply the input value 108a by the weight value 122a (e.g., a₁*W₁). In certain embodiments, the weight values 122 may be updated based on, e.g., a feedback loop during training of the artificial neural network 100.

The hardware neuron 110 may further include bias operation circuitry 116, which may be configured to perform an operation on output from the weight operation circuitry 114, such as an adder or summation operation. For example, the bias operation circuitry 116 may add the one or more bias values 124 to weighted values output from the weight operation circuitry 114. The bias values 124 may be stored in storage circuitry 118 proximate to the hardware neuron 110 and/or the bias operation circuitry 116. The bias operation circuitry 116 may read the bias values 124 from the storage circuitry 118 and may add the bias values 124 to the weighted values output from the weight operation circuitry 114. In some embodiments, the bias operation circuitry 116 may add the bias values 124 using summation circuitry. As a specific example, a weighted value output from the weight operation circuitry 114 (e.g., the weighted value [a₁*W₁] for the input value 108a) may be added to the bias value 124 (e.g., the bias operation circuitry 116 may produce a biased weighted value of sum(a₁*W₁ +b₁)).

Storage circuitry 118 (e.g., configured as storage bit(s) or configuration bit(s)) may additionally be included in the hardware neuron 110. The storage circuitry 118 may include non-volatile memory, such as MRAM bits, that stores one or more weight values or bias values. For example, the storage circuitry 118a, 118b may store weight values 122a, 122b, which the weight operation circuitry 114a, 114b may read, respectively. As another example, the storage circuitry 118c may store bias value 124, which the bias operation circuitry 116 may read.

The storage circuitry 118 may store a single bit or may store multiple bits for different operating configurations. For example, the storage circuitry 118a may store a first weight value for a first operating condition, a second weight value for a second operating condition, and so forth. As described in more detail herein, the storage circuitry 118 may include a bridge element (e.g., an MTJ bridge) and a voltage amplifier circuit for each bit.

In this way, the hardware neuron 110 may be associated with multiple sets of storage circuitry 118, each set corresponding to different operation circuitry 114, 116. In addition, in this way, the storage circuitry 118 may be proximate to the corresponding operation circuitry 114, 116, which may reduce power consumption and/or latency for reading values from the storage circuitry 118. Depending on the circuitry layout of the hardware neuron 110, certain embodiments may include combined storage circuitry 118 for the weight operation circuitry 114a, 114b (e.g., storage circuitry 118a, 118b may be combined into one set of storage circuitry 118 with storage circuitry 118c being a separate set of storage circuitry 118); or storage circuitry 118a, 118c may be combined into one set of storage circuitry 118, despite storing different types of values.

The storage circuitry 118 (e.g., MRAM storage bits or configuration bits) may comprise one or more MTJs or other types of resistive elements. For example, and as described in more detail herein, the storage circuitry 118 may include a bridge element of multiple MTJs. The MTJs may have write and read capability using product voltage drain supply (VDD), such as 0.8V, 1V, 1.2V, or 1.5V.

As further illustrated in FIG. 2, the bias operation circuitry 116 may output a result of performing certain operations to the activation function circuitry 120, which may implement a ReLU activation function or a sigmoid activation function. The activation function circuitry 120 may output a value to a hardware neuron 112 of the output layer 106. The hardware neuron 112 may include similar circuitry configurations as described for the hardware neuron 110. For example, different sets of operation circuitry of the hardware neuron 112 may each be associated with a set of storage circuitry 118 for storing values used in the operations of the output layer 106 of the hardware neuron 112. The storage circuitry of the hardware neuron 112 may be distinct from the storage circuitry 118 of the hardware neuron 110, e.g., to facilitate proximate location of the storage circuitry 118 of the hardware neuron 112 to components of the hardware neuron 112.

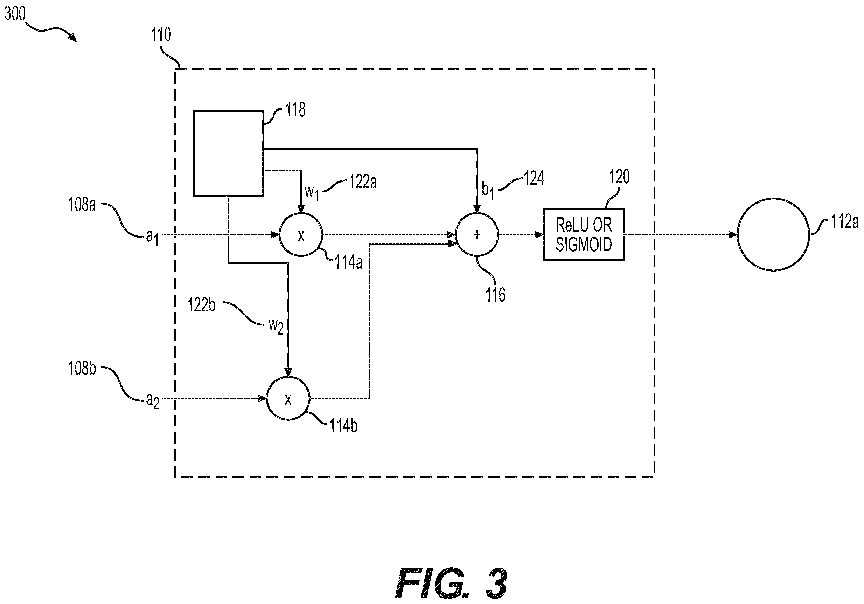

FIG. 3 depicts an example 300 of a second hardware neuron 110 of the artificial neural network 100 of FIG. 1, according to an exemplary embodiment of the present disclosure. For example, FIG. 3 depicts a functional diagram of the hardware neuron 110 of the artificial neural network 100 of FIG. 1 (e.g., FIG. 3 depicts an alternative configuration for the hardware neuron 110 from that depicted in FIG 2).

As illustrated, the hardware neuron 110 of FIG. 3 may include weight operation circuitry 114a, 114b, bias operation circuitry 116, and activation function circuitry 120 similar to the example 200 illustrated in FIG. 2. The hardware neuron 110 may further include storage circuitry 118. However, rather than including multiple sets of storage circuitry 118 for different operation circuitry 114, 116, the example 300 may include one set of storage circuitry 118 for storing the weight values 122a, 122b and the bias value 124. In the example 300, the storage circuitry 118 may include a mini array, and different hardware neurons 110 of the artificial neural network 100 may include different mini arrays. In some embodiments, an artificial neural network 100 may include multiple arrays of storage circuitry 118 (rather than a single array illustrated in FIG. 3) distributed across the artificial neural network 100. For example, each of the hardware neurons 110 of the hidden layer 104 and/or each of the hardware neurons 112 of the output layer 106 may include an array similar to that illustrated in FIG. 3 as the storage circuitry 118.

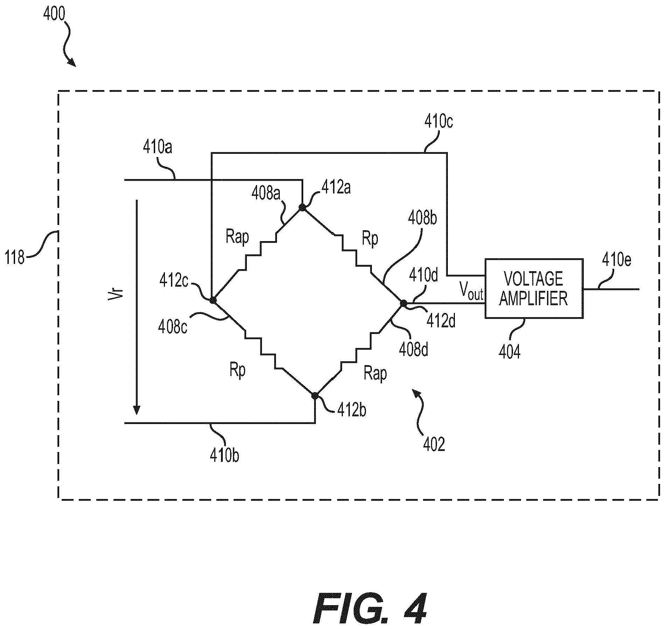

FIG. 4 depicts a configuration 400 of exemplary storage circuitry 118 of a hardware neuron, according to an exemplary embodiment of the present disclosure. For example, FIG. 4 depicts circuitry of a multi-time programmable storage circuitry 118 (e.g., a storage or a configuration bit) configured for read-out of a first value or a second value, according to an exemplary embodiment of the disclosure. For example, the storage circuitry 118 may be a MRAM (e.g., toggle MRAM or spin-transfer torque (STT) MRAM) or a ReRAM that can be re-programmed multiple times to represent different values. The circuitry of the storage circuitry 118 illustrated in FIG. 4 may read out a first value (e.g., a 0 value of a binary 0 and 1 system) or a second value (e.g., a 1 value of the binary 0 and 1 system).

As illustrated, the storage circuitry 118 may include a MTJ bridge 402, a voltage amplifier 404, and an inverter (not illustrated in FIG 4). The MTJ bridge 402 may include one or more resistive elements 408 (e.g., resistive elements 408a, 408b, 408c, and 408d). Although FIG. 4 illustrates the MTJ bridge 402 as including four resistive elements 408, certain embodiments may include any number of multiple resistive elements 408 greater than four (e.g., 5, 6, 7, 8, etc. resistive elements). A resistive element 408 may include an MTJ or another type of electrical component capable of providing resistance to a flow of electrical current. For example, a resistive element 408 may have multiple resistance states (e.g., a low resistance state (parallel), Rp, and a high resistance state (antiparallel), Rap).

The MTJ bridge 402 may further include one or more electrodes 412 (e.g., electrodes 412a, 412b, 412c, and 412d) to electrically connect different resistive elements 408 in series or in parallel. For example, MTJ bridge 402 may include four resistive elements, where two first resistive elements are electrically connected in series and two second resistive elements are electrically connected in series and where the first resistive elements are electrically connected in parallel to the second resistive elements. As a specific example, the resistive elements 408a, 408b (forming a first group of resistive elements 408) may be electrically connected in series via the electrode 412a, the resistive elements 408c, 408d (forming a second group of resistive elements 408) may be electrically connected in series via the electrode 412b, and the first group and second group of resistive elements may be electrically connected in parallel via the electrodes 412c, 412d.

As further illustrated in FIG. 2, the storage circuitry 118 may include one or more electrical connections 410 (e.g., electrical connections 410a, 410b, 410c, 410d, and 410e). The electrical connection 410a may electrically connect the electrode 412a to a voltage supply (not illustrated in FIG. 4) and the electrical connection 410b may electrically connect the electrode 412b to the voltage supply. The electrical connection 410c may electrically connect the electrode 412c to an input of the voltage amplifier 404 and the electrical connection 410d may electrically connect the electrode 412d to the input of the voltage amplifier 404. The electrical connection 410e may electrically connect an output of the voltage amplifier to an inverter (not illustrated in FIG 4). The inverter may be in different states depending on whether the gate of the inverter is open or closed. The inverter may be in a first state (e.g., a 1 state) indicative of a first value (e.g., a 1 value) based on applied voltage to the MTJ bridge 402.

As described above, the resistive elements 408 may have two resistance states (e.g., a high resistance state, Rap, and a low resistance state, Rp). For the first state of the inverter, the resistive elements 408a, 408d may be in the high resistance state and the resistive elements 408b, 408c may be in the low resistance state. For a second state of the inverter, the resistive elements 408a, 408d may be in the low resistance state and the resistive elements 408b, 408c may be in the high resistance state.

In some embodiments, the MTJ bridge 402 of the storage circuitry 118 illustrated in FIG. 4 may store one bit, and the storage circuitry 118 may be configured with multiple instances of the MTJ bridges 402 illustrated in FIG. 4 for multiple bits. The MTJ bridges 402 may be read, multi-time programmed (MTP), and/or one-time programmed (OTP), as described elsewhere herein.

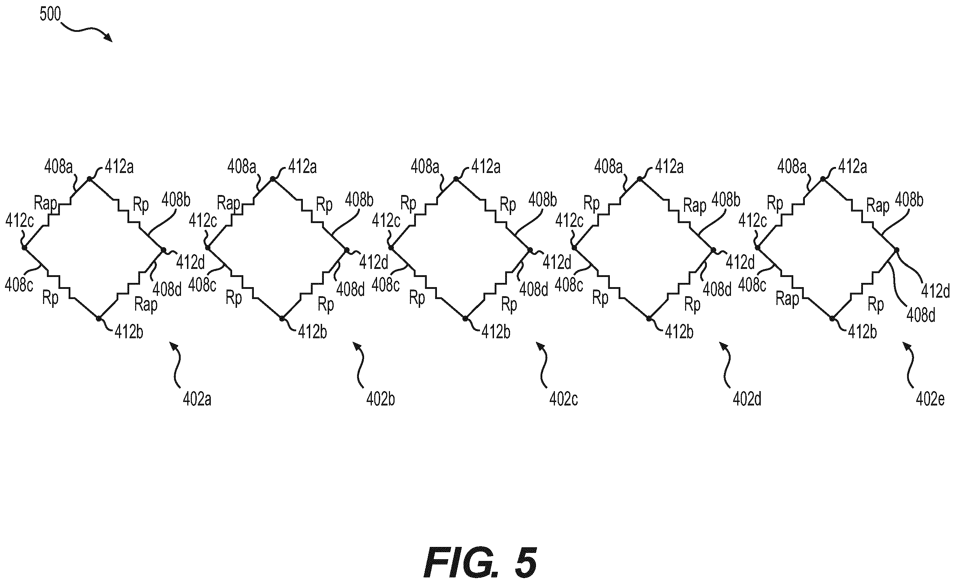

FIG. 5 depicts various bridge element configurations 500 of storage circuitry 118 of a hardware neuron 110, according to an exemplary embodiment of the present disclosure. For example, the different bridge element configurations 402a, 402b, 402c, 402d, and 402e may provide for storage of different values. In configurations where the storage circuitry 118 includes multiple bits (e.g., multiple instances of the MTJ bridge 402), the storage circuitry 118 may include multiple of the bridge element configurations 500, which can each be configured to the same or different values based on the configurations 500. In other configurations where the storage circuitry 118 includes a single bit (e.g., a single instance of the MTJ bridge 402), the storage bit may be multi-time programmed into the configurations 500 for storing different values.

The bridge element configurations 500 may store different values based on the different resistance (Rp and Rap) configurations of the resistive elements 408. For example, the resistance values for one or more resistors and/or effective resistors (e.g., four MTJs as resistive elements 408) may be configured to output various combinations of bit values. A single MTJ bridge 402 may output two or more states based on its configured (e.g., stored) resistance values. A voltage amplifier having multiple threshold levels may be used to output multiple states (e.g., more than two outputs) from the same MTJ bridge element 402.

Accordingly, one or more configuration bits may use MTJ bridges 402 to store larger amounts or more complex data using various resistive configuration bits. For example, an artificial neural network 100 may have to store weight values and/or bias values using multiple bits. The one or more configurations of resistive elements 408 (e.g., by modifying resistive values) may be used to store the weight values and/or bias values using multiple bits. In this way, a bridge element 402 may be used to store one or more bits of data based on the different configurations 500. In some embodiments, the configurations 500 may include one or more sensing circuits.

In this way, although an artificial neural network 100 may have to use a large amount of storage space (e.g., on the order of gigabits or more) across the artificial neural network 100, certain embodiments described herein may provide for small storage space (e.g., 1 to 8 MRAM bits) located proximate to hardware neurons 110, 112 (or operation circuitry of the hardware neurons 110, 112). This may facilitate sizing of storage circuitry (e.g., storage circuitry 118) based on operations of the hardware neurons 110, 112 rather than based on operations of the entire artificial neural network 100. This may conserve chip space, allow for faster and lower power access of stored information by the hardware neurons 110, 112, and/or the like.

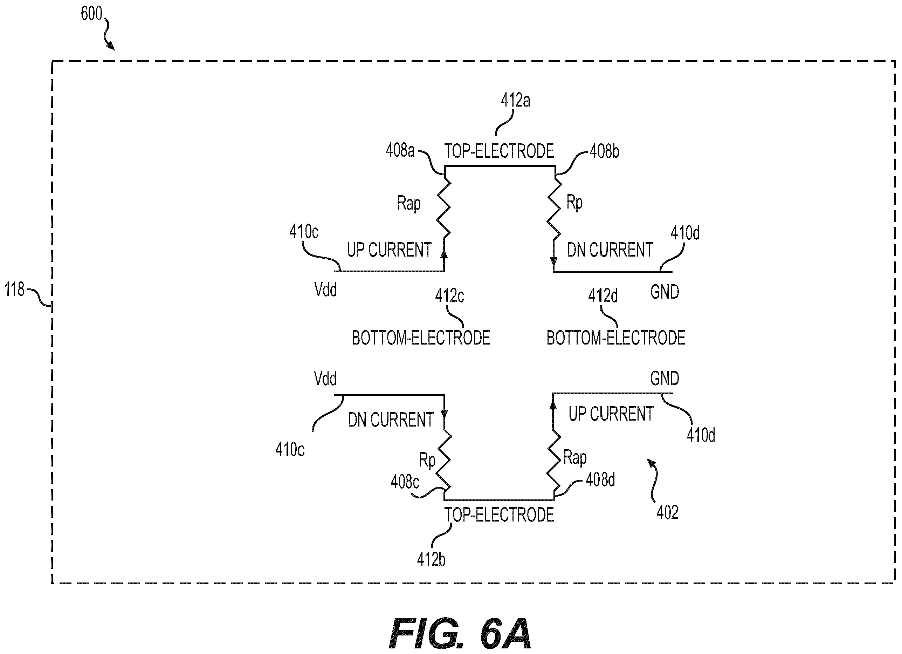

FIG. 6A depicts an example 600 of a multi-time programmable storage circuitry 118, of a hardware neuron (e.g., a hardware neuron 110 or a hardware neuron 112), configured for writing of a first value, according to an exemplary embodiment of the disclosure. The example 600 may include an MTJ bridge 402, a voltage amplifier 404, an inverter, resistive elements 408, electrical connections 410, and electrodes 412 (some of which are not illustrated in FIG. 6A for explanatory purposes) configured in a manner similar to the configuration 400 illustrated in FIG. 4.

An inverter (not illustrated in FIG. 6A) may be in a first state (e.g., a 0 state) indicative of a first value (e.g., a 0 value) based on a positive Vdd applied to the electrode 412c (e.g., a first bottom electrode) and a ground voltage (GND) applied to the electrode 412d (e.g., a second bottom electrode). In this state, based on applying the Vdd and the GND, current may flow from the electrode 412c up through the resistive element 408a and down through the resistive element 408c, through the electrodes 412a, 412b (e.g., top-electrodes), and down through the resistive element 408b and up through the resistive element 408d to the electrode 412d. The positive Vdd applied to the electrode 412c may be higher than a switching voltage for a resistive element, and lower than a breakdown voltage for the resistive element.

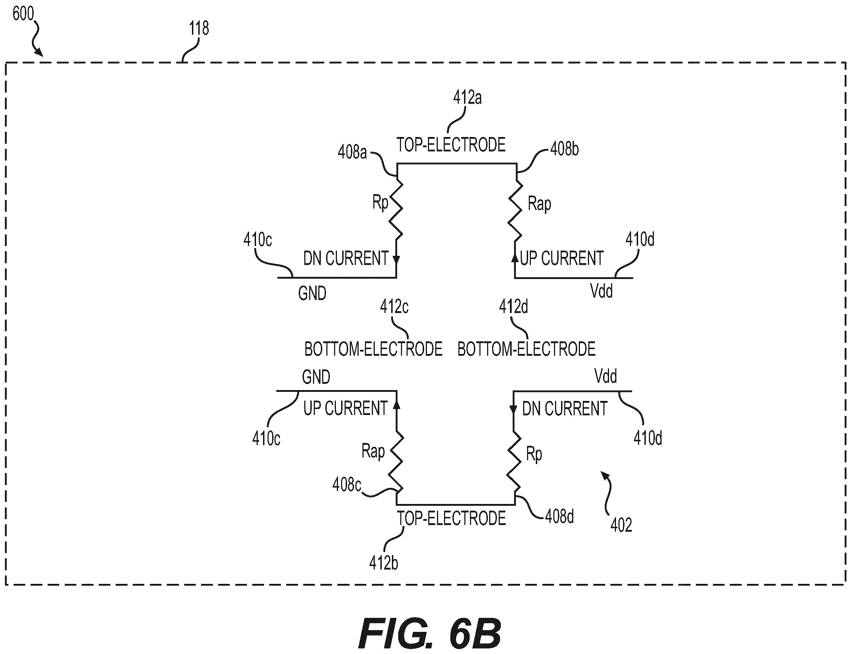

Turning to FIG. 6B, there is depicted an example 600 of circuitry of a multi-time programmable storage circuitry 118 configured for writing of a second value, according to an exemplary embodiment of the disclosure. The example 600 may include an MTJ bridge 402, a voltage amplifier 404, an inverter, resistive elements 408, electrical connections 410, and electrodes 412 (some of which are not illustrated in FIG. 6B for explanatory purposes) configured in a manner similar to the example 600 illustrated in FIG. 6B.

An inverter (not illustrated in FIG. 6B) may be in a second state (e.g., a 1 state) indicative of a second value (e.g., a 1 value) based on a positive Vdd applied to the electrode 412d (e.g., a second bottom-electrode) and a GND voltage applied to the electrode 412c (e.g., a first bottom-electrode). In this state, based on applying the Vdd and the GND, current may flow from the electrode 412d up through the resistive element 408b and down through the resistive element 408d, through the electrodes 412a, 412b (e.g., top-electrodes), and down through the resistive element 408a and up through the resistive element 408c to the electrode 412c.

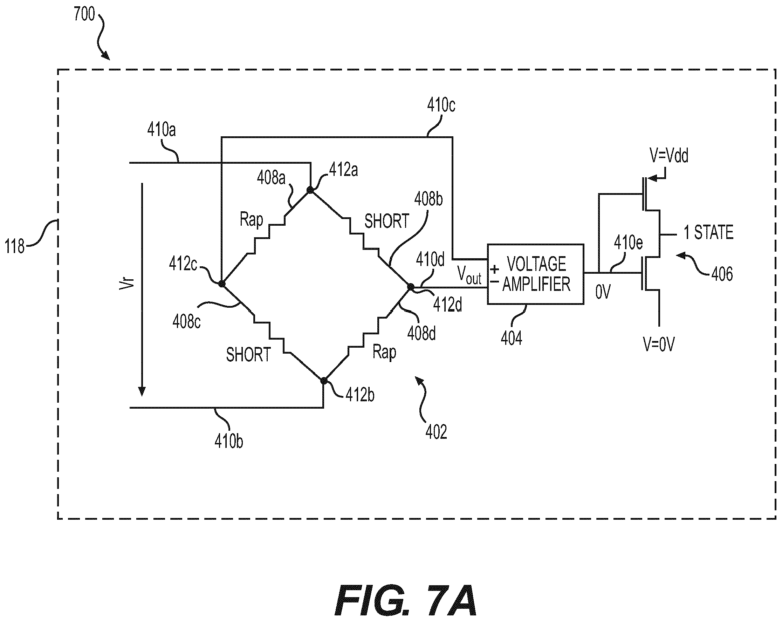

FIG. 7A depicts an example 700 of circuitry of a one-time programmable storage circuitry 118, of a hardware neuron, configured for read-out of a first value, according to an exemplary embodiment of the disclosure. For example, the storage circuitry 118 may not be re-programmable to another value. The example 700 may include an MTJ bridge 402, a voltage amplifier 404, an inverter 406, resistive elements 408, electrical connections 410, and electrodes 412 configured in a manner similar to the configuration 400 illustrated in FIG. 4. However, rather than having resistive elements 408b, 408c in a low or high resistance state, the resistive elements 408b, 408c may be shorted (identified by "SHORT" in FIG. 7A). The shorting of these resistive elements may cause the inverter 406 to be permanently in a first state (e.g., a 1 state) indicative of a first value (e.g., a 1 value).

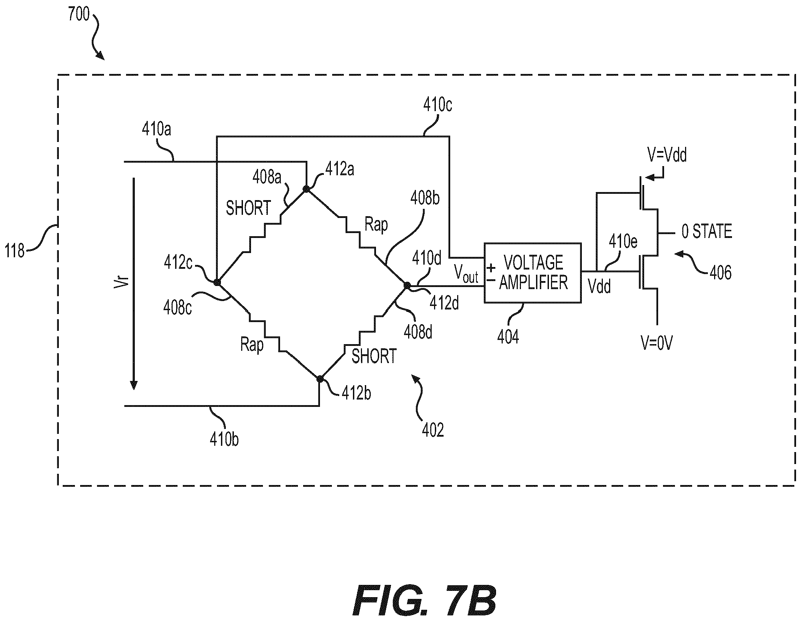

Turning to FIG. 7B, there is depicted an example 700 of circuitry of a one-time programmable storage circuitry 118, of a hardware neuron (e.g., a hardware neuron 110 or a hardware neuron 112), configured for read-out of a second value, according to an exemplary embodiment of the disclosure. For example, the storage circuitry 118 may not be re-programmable to another value. The example 700 may include an MTJ bridge 402, a voltage amplifier 404, an inverter 406, resistive elements 408, electrical connections 410, and electrodes 412 configured in a manner similar to the example 400 illustrated in FIG. 4. However, rather than having resistive elements 408a and 408d in a low or high resistance state, the resistive elements 408a and 408d may be shorted. The shorting of these resistive elements 408 may cause the inverter 406 to be permanently in a second state (e.g., a 0 state) indicative of a second value (e.g., a 0 value).

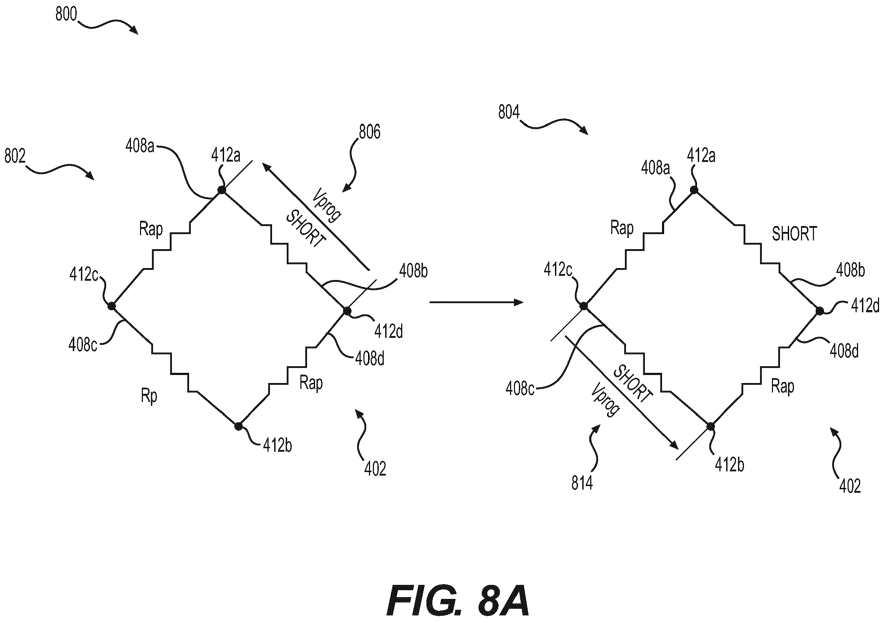

FIG. 8A depicts an exemplary one-time programming 800 of storage circuitry 118 of a storage bit with a first value, according to an exemplary embodiment of the disclosure. The circuitry may include an MTJ bridge 402, a voltage amplifier 404, an inverter, resistive elements 408, electrical connections 410, and electrodes 412 (some of which are not illustrated in FIG. 8A for explanatory purposes) similar to that described elsewhere herein. The resistive elements 408a, 408b may form a first group of resistive elements 408 and the resistive elements 408c, 408d may form a second group of resistive elements 408.

The programming may include two steps 802, 804 to configure the circuitry in the manner similar to that described above in connection with the example 700 of FIG. 7A. The first step 802 may include applying various voltages across the resistive elements 408 (e.g., at the same time or at different times). For example, a relatively high (compared to Vdd) programming voltage (Vprog) 806 may be applied across the resistive element 408b (one of the first group of resistive elements 408) to short the resistive element 408b. In this way, a positive voltage may be applied across the resistive element 408b from the electrode 412d to the electrode 412a to program the storage circuitry 118 with the first value.

The second step 804 may include applying various voltages across the resistive elements 408 (e.g., at the same time or at different times). For example, a relatively high (compared to Vdd) programming voltage (Vprog) 814 may be applied across the resistive element 408c (the one of the second group of resistive elements 408) to short the resistive element 408c. In this way, a positive voltage may be applied across the resistive element 408c from the electrode 412b to the electrode 412c to program the storage circuitry 118 with the first value.

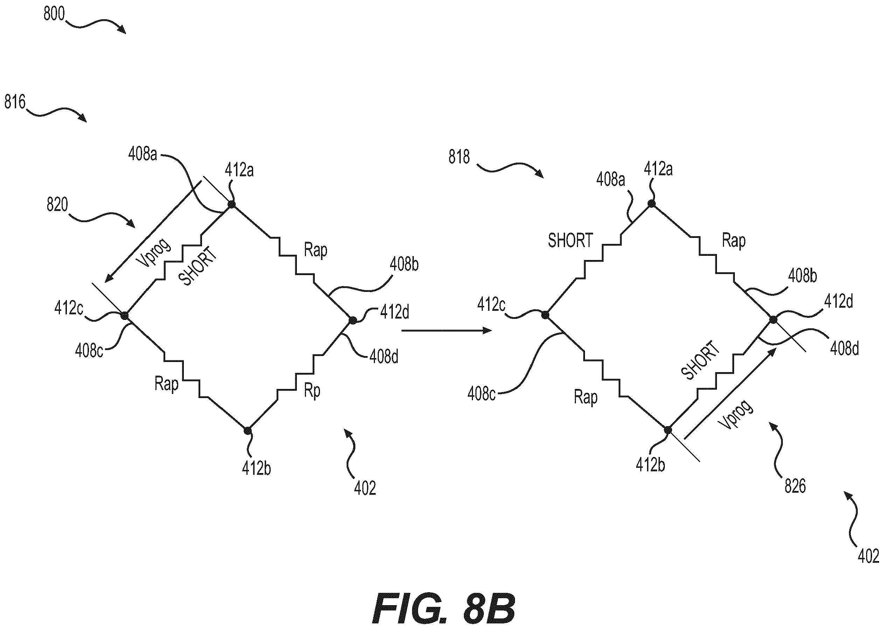

Turning to FIG. 8B, there is depicted an exemplary one-time programming 800 of storage circuitry 118 of a storage bit with a second value, according to an exemplary embodiment of the disclosure. The circuitry may include an MTJ bridge 402, a voltage amplifier 404, an inverter, resistive elements 408, electrical connections 410, and electrodes 412 (some of which are not illustrated in FIG. 8B for explanatory purposes) similar to that described elsewhere herein. The resistive elements 408a, 408b may form a first group of resistive elements 408 and the resistive elements 408c, 408d may form a second group of resistive elements 408.

The programming may include two steps 816, 818 to configure the circuitry in the manner similar to that described above in connection with the example 700 of FIG. 7B. The first step 816 may include applying various voltages across the resistive elements 408 (e.g., at the same time or at different times). For example, a relatively high Vprog 820 may be applied across the resistive element 408a (one of the first group of resistive elements 408) to short the resistive element 408a. In this way, a positive voltage may be applied across the resistive element 408a from the electrode 412c to the electrode 412a to program the storage circuitry 118 with the second value.

The second step 818 may include applying various voltages across the resistive elements 408 (e.g., at the same time or at different times). For example, a relatively high Vprog 826 may be applied across the resistive element 408d (the one of the second group of resistive elements 408) to short the resistive element 408d. In this way, a positive voltage may be applied across the resistive element 408d from the electrode 412b to the electrode 412d to program the storage circuitry 118 with the second value.

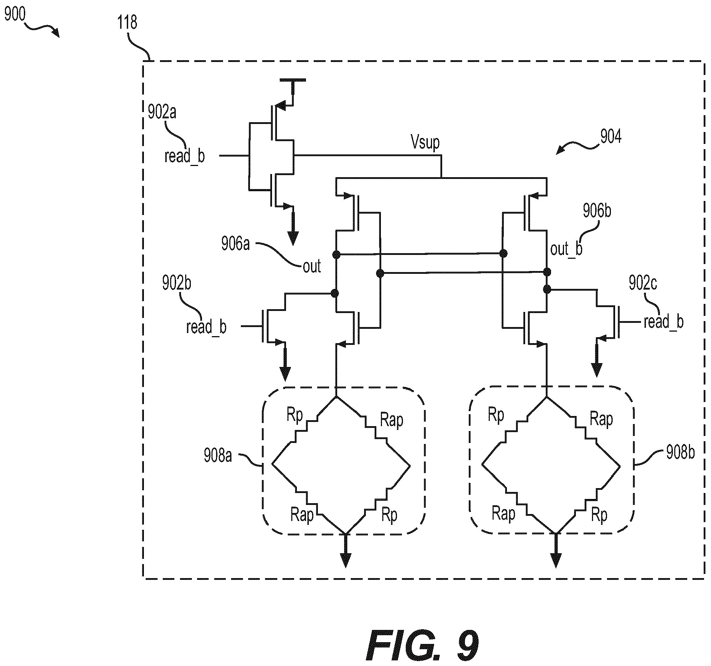

FIG. 9 depicts an example configuration 900 of storage circuitry 118 of a hardware neuron (e.g., a hardware neuron 110 or a hardware neuron 112), according to an exemplary embodiment of the present disclosure. For example, FIG. 9 illustrates an alternative to the configurations for the storage circuitry 118 illustrated in FIGs. 4-8b. The example configuration 900 may include various sets of read circuitry 902. For example, the storage circuitry 118 may include read circuitry 902a that includes two transistors, read circuitry 902b that includes one transistor, and read circuitry 902c that includes one transistor. The read circuitry 902a may be electrically connected to cross-coupled inverter circuitry 904 via a voltage supply (Vsup) connection. The cross-coupled inverter circuitry 904 may include four transistors and may include output circuitry 906a (labeled "out" in FIG. 9) and 906b (labeled "out_b" in FIG 9). The read circuitry 902b may be associated with storage bit circuitry 908a and may read a value stored in the storage bit circuitry 908a. The read circuitry 902c may be associated with storage bit circuitry 908b and may read a value stored in the storage bit circuitry 908b.

The cross-coupled inverter circuitry 904 may produce outputs out and out_b (out_b may be the opposite polarity signal of the out output) that indicate MRAM storage bit state. During a read operation, the read circuitry 902a may transition from VDD to ground (Gnd) causing Vsup to transition from Gnd to VDD and causing out/out_b to no longer be pulled down to Gnd. Current differences between the storage bit circuitry 908a and 908b may cause the out and out_b circuitry to provide full swing (Gnd or VDD) outputs. MTJ states in the storage bit circuitry 908a and 908b may create current differences. Storage bit circuitry 908a or 908b can be implemented with a single MTJ or a series of two or more MTJs to reduce MTJ variation. Alternative configurations of the embodiments illustrated in FIG. 9 are possible. For example, an MTJ bridge can be connected to the cross-coupled inverter circuitry 904 in any other configuration to respond to voltage or current differences.

Series connection of MTJs in the storage bit circuitry 908a and 908b may help to ensure that read current through any MTJ is minimized to avoid any read disruption of the stored MTJ states. During a write operation, other p-type metal-oxide-semiconductor (PMOS) and n-type metal-oxide-semiconductor (NMOS) transistors (not shown in FIG. 9) may be connected to the MTJ bridges to write one or more MTJs at a time (e.g., write two or multiples of two MTJs at a time). Thus, write current may pass through at least two MTJs in series, in a manner similar to that illustrated in FIGs. 6a-7b. In this way, certain embodiments may provide for no static current draw after a storage bit is read. Alternate embodiments, not shown here, with cross-coupled inverter circuitry similar to that illustrated in FIG. 9, may be used to perform the same function as described above. For example, the MTJ bridges 908a, 908b may reside between the Vsup node and cross-coupled-inverter circuitry 904. Additional NMOS transistors acting as follower circuitry may control the applied voltage across the MTJ bridges 908a, 908b.

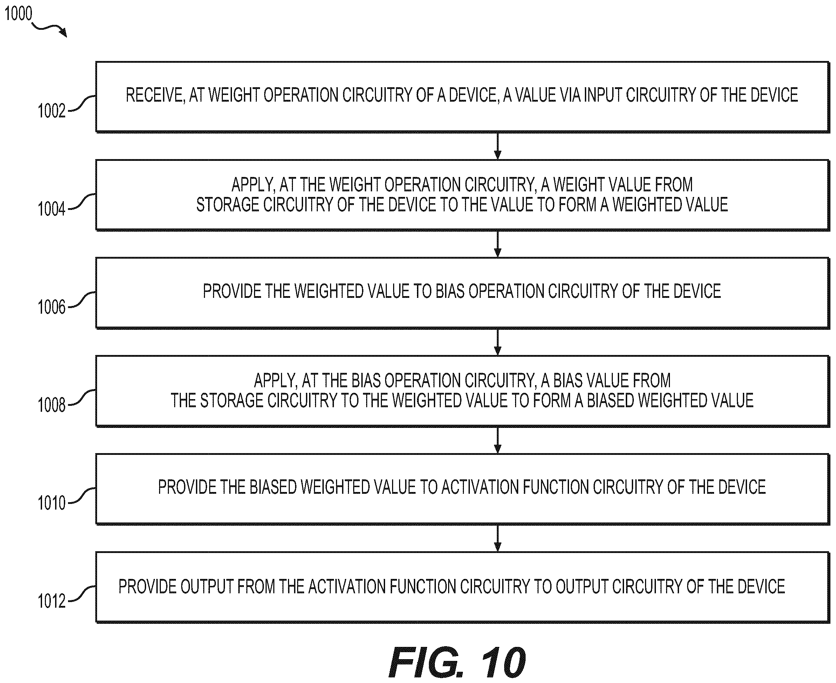

FIG. 10 depicts a flowchart for an exemplary method 1000 for operation of a hardware neuron 110, according to an aspect of the present disclosure. For example, the method 1000 may use the hardware neuron 110 in connection with operations of an artificial neural network 100.

In step 1002, the method 1000 may include receiving, at weight operation circuitry of a device, a value via input circuitry of the device. For example, a hardware neuron 110 may receive, at weight operation circuitry 114 of the hardware neuron 110, a value 108 via input circuitry of an input layer 102. In the context of FIGs. 2 and 3 described above, the hardware neuron 110 may receive the values 108a and 108b at the weight operation circuitry 114, respectively. The hardware neuron 110 may receive the value as part of a training process for an artificial neural network 100, and may receive various input values 108 throughout the training process.

In step 1004, the method 1000 may include applying, at the weight operation circuitry, a weight value from storage circuitry of the device to the value to form a weighted value. For example, the hardware neuron 110 may apply, at the weight operation circuitry 114, a weight value 122 from the storage circuitry 118 of the hardware neuron 110 to form a weighted value. The applying may include the hardware neuron 110 multiplying the value 108 by the weight value 122 using the weight operation circuitry 114. For example, and as described elsewhere herein, the hardware neuron 110 may multiply the value a₁ by the weight value W₁ to form the product a₁W₁. In the context of FIG. 2 described above, the hardware neuron 110 may apply the weight value 122a from the storage circuitry 118a to the input value 108a at the weight operation circuitry 114a and may apply the weight value 122b from the storage circuitry 118b to the input value 108b at the weight operation circuitry 114b. In the context of FIG. 3 described above, the hardware neuron 110 may apply the weight value 122a from the storage circuitry 118 to the input value 108a at the weight operation circuitry 114a and may apply the weight value 122b from the storage circuitry 118 to the input value 108b at the weight operation circuitry 114b.

In some embodiments, the weight operation circuitry 114 may read the weight value 122 from the storage circuitry 118, may receive a transmission of the weight value 122 from the storage circuitry 118, and/or the like in connection with applying the weight value 122 to the input value 108.

The method 1000 may include, at step 1006, providing the weighted value to bias operation circuitry of the device. For example, the hardware neuron 110 may provide the weighted value to bias operation circuitry 116 of the hardware neuron 110. As a specific example, the hardware neuron 110 may provide the weighted value a₁W₁ from the weight operation circuitry 114 to the bias operation circuitry 116 after applying the weight value 122 to the input value 108. In the context of FIGs. 2 and 3, the hardware neuron 110 may provide the weighted values calculated at the weight operation circuitry 114a, 114b to the bias operation circuitry 116.

At step 1008, the method 1000 may include applying, at the bias operation circuitry, a bias value from the storage circuitry to the weighted value to form a biased weighted value. For example, the hardware neuron 110 may apply, at the bias operation circuitry 116, a bias value 124 from the storage circuitry 118 to the weighted value to form a biased weighted value. In the context of FIG. 2, the hardware neuron 110 may apply, at the bias operation circuitry 116, the bias value 124 from the storage circuitry 118c to the weighted values received from the weight operation circuitry 114a, 114b. As a specific example, the bias operation circuitry 116 may add the bias value 124 to the weighted value from the weight operation circuitry 114 (e.g., the bias operation circuitry 116 may produce a biased weighted value of sum(a₁*W₁ +b₁)). In the context, of FIG. 3, the hardware neuron 110 may apply, at the bias operation circuitry 116, the bias value 124 from the storage circuitry 118 to the weighted values received from the weight operation circuitry 114a, 114b.

The method 1000 may include, at 1010, providing the biased weighted value to activation function circuitry of the device. For example, the hardware neuron 110 may provide the biased weighted value from the bias operation circuitry 116 to activation function circuitry 120 after applying the bias value 124 to the weighted value from the weight operation circuitry 114. In the context of FIGs. 2 and 3, the hardware neuron 110 may provide the sum(a₁*W₁ +b₁) and the sum(a₂*W₂ +b₂) to the activation function circuitry 120 from the bias operation circuitry 116.

The method 1000 may include, at 1012, providing output from the activation function circuitry to output circuitry of the device. For example, the hardware neuron 110 may provide output from the activation function circuitry 120 to output circuitry of the hardware neuron 110 and then to a hardware neuron 112 of an output layer 106.

Certain embodiments described herein may include additional or alternative aspects. As one example aspect, the storage circuitry 118 may be re-programmed with updated weight values 122 or bias values 124, and certain operations of the method 1000 maybe re-performed based on the updated values.

Certain embodiments described herein may provide for toleration of a high error rate in artificial neural network 100 applications. In this way, acceptable and unacceptable error rates may be identified based on the error rate tolerance and, in some embodiments, error correction code (ECC) may be omitted based on the high error ate tolerance or may be implemented such that the ECC is activated if the high error rate tolerance is met. Thus, storage bits may implement ECC bits and ECC correction depending on the bit error rate needed. This may conserve resources and/or chip space associated with implementing ECC or implementing ECC at a lower error rate threshold.

In this way, certain embodiments described herein may provide for on-chip storage of values using circuitry proximate to the circuitry that is to use the values. Using such on-chip storage, the time and computing resource cost (e.g., power consumption) of retrieving, storing, and/or updating such values may be reduced. Certain embodiments disclosed herein, such as MTJ-based circuitry configurations may provide for multi-bit storage with each MTJ bridge. Additionally, or alternatively, the on-chip access to storage may reduce or eliminate the risk of connection loss that would otherwise be associated with external memory access. Additionally, or alternatively, certain embodiments may provide for enhanced security of weight values and/or bias values for a trained network, such as in an inference application. Additionally, or alternatively, certain embodiments may provide for writing of storage bits in an MTP mode, such as in a training application, which may conserve power and/or reduce latency compared to using off-chip non-volatile memory. For example, in learning applications, the weight values 122 and bias values 124 may have to be adjusted continuously resulting in frequent memory access; and having multi-time programmable storage circuitry 118 located proximate to operation circuitry 114, 116 may reduce training time and power consumption associated with training.

In one embodiment, a device may comprise: input circuitry; weight operation circuitry electrically connected to the input circuitry; bias operation circuitry electrically connected to the weight operation circuitry; storage circuitry electrically connected to the weight operation circuitry and the bias operation circuitry; and activation function circuitry electrically connected to the bias operation circuitry, wherein at least the weight operation circuitry, the bias operation circuitry, and the storage circuitry are located on a same chip.

Various embodiments of the device may include: wherein the weight operation circuitry comprises first weight operation circuitry and second weight operation circuitry, and wherein the storage circuitry comprises first storage circuitry electrically connected to the first weight operation circuitry, second storage circuitry electrically connected to the second weight operation circuitry, and third storage circuitry electrically connected to the bias operation circuitry; wherein the weight operation circuitry comprises first weight operation circuitry and second weight operation circuitry, and wherein the storage circuitry is electrically connected to the first weight operation circuitry, the second weight operation circuitry, and the bias operation circuitry; wherein the storage circuitry comprises one or more storage bits; wherein the one or more storage bits each comprise one or more resistive elements and a voltage amplifier; wherein the one or more resistive elements comprise at least four resistive elements, wherein at least two first resistive elements are electrically connected in series and at least two second resistive elements are electrically connected in series, wherein the at least two first resistive elements are electrically connected in parallel to the at least two second resistive elements, and wherein an input of the voltage amplifier is electrically connected to a first electrode between the at least two first resistive elements and connected to a second electrode between the at least two second resistive elements; wherein each of the one or more resistive elements comprise a magnetic tunnel junction (MTJ); wherein the one or more storage bits are included in a single array of bits; wherein the device comprises a hardware neuron in an artificial neural network; the device further comprising output circuitry electrically connected to the activation function circuitry; wherein each of the one or more storage bits comprises: a first set of resistive elements and a second set of resistive elements, first read circuitry electrically connected to the first set of resistive elements and second read circuitry electrically connected to the second set of resistive elements, cross-coupled inverter circuitry electrically connected to the first read circuitry and the second read circuitry, and third read circuitry electrically connected to the cross-coupled inverter circuitry.

In another embodiment, a neuron device of an artificial neural network may comprise: input circuitry; weight operation circuitry electrically connected to the input circuitry; bias operation circuitry electrically connected to the weight operation circuitry; storage circuitry electrically connected to the weight operation circuitry and the bias operation circuitry; and activation function circuitry electrically connected to the bias operation circuitry, wherein at least the weight operation circuitry, the bias operation circuitry, and the storage circuitry are located on a same chip.

Various embodiments of the neuron device may include: wherein the weight operation circuitry comprises first weight operation circuitry and second weight operation circuitry, and wherein the storage circuitry comprises first storage circuitry electrically connected to the first weight operation circuitry, second storage circuitry electrically connected to the second weight operation circuitry, and third storage circuitry electrically connected to the bias operation circuitry; wherein the weight operation circuitry comprises first weight operation circuitry and second weight operation circuitry, and wherein the storage circuitry is electrically connected to the first weight operation circuitry, the second weight operation circuitry, and the bias operation circuitry; wherein the storage circuitry comprises one or more storage bits, wherein each of the one or more storage bits comprises one or more resistive elements and a voltage amplifier; wherein the one or more resistive elements comprise at least four resistive elements, wherein at least two first resistive elements are electrically connected in series and at least two second resistive elements are electrically connected in series, wherein the at least two first resistive elements are electrically connected in parallel to the at least two second resistive elements, and wherein an input of the voltage amplifier is electrically connected to a first electrode between the at least two first resistive elements and to a second electrode between the at least two second resistive elements; wherein the one or more storage bits are included a single array of bits; the neuron device further comprising output circuitry electrically connected to the activation function circuitry; wherein each of the one or more storage bits comprises: a first set of resistive elements and a second set of resistive elements, first read circuitry electrically connected to the first set of resistive elements and second read circuitry electrically connected to the second set of resistive elements, cross-coupled inverter circuitry electrically connected to the first read circuitry and the second read circuitry, third read circuitry electrically connected to the cross-coupled inverter circuitry.

In yet another embodiment, a method of operating a device of an artificial neural network may include: receiving, at weight operation circuitry of the device, a value via input circuitry of the device; applying, at the weight operation circuitry, a weight value from storage circuitry of the device to the value to form a weighted value; providing the weighted value to bias operation circuitry of the device; applying, at the bias operation circuitry, a bias value from the storage circuitry to the weighted value to form a biased weighted value; and providing the biased weighted value to activation function circuitry of the device, wherein at least the weight operation circuitry, the bias operation circuitry, and the storage circuitry are located on a same chip.

While principles of the present disclosure are described herein with reference to illustrative examples for particular applications, it should be understood that the disclosure is not limited thereto. For example, instead of a MTJ-based bitcell, another memory bit such as resistive RAM or Ferroelectric RAM bit technology may be used to design the antifuse circuitry with the present disclosure. Another memory bit may have a programmed state and at least one unprogrammed state. The at least one unprogrammed state may further comprise a plurality of unprogrammed states, for example, a low unprogrammed state, a high unprogrammed state, and one or more intermediate unprogrammed states. Those having ordinary skill in the art and access to the teachings provided herein will recognize additional modifications, applications, embodiments, and substitution of equivalents all fall within the scope of the features described herein. Accordingly, the claimed features are not to be considered as limited by the foregoing description.

The foregoing description of the inventions has been described for purposes of clarity and understanding. It is not intended to limit the inventions to the precise form disclosed. Various modifications may be possible within the scope and equivalence of the application.

It follows a list of further embodiments of the invention:
Embodiment 1. A device, comprising:
   input circuitry;
   weight operation circuitry electrically connected to the input circuitry;
   bias operation circuitry electrically connected to the weight operation circuitry;
   storage circuitry electrically connected to the weight operation circuitry and the bias operation circuitry; and
   activation function circuitry electrically connected to the bias operation circuitry,
      wherein at least the weight operation circuitry, the bias operation circuitry, and the storage circuitry are located on a same chip.
Embodiment 2. The device of embodiment 1, wherein the weight operation circuitry comprises first weight operation circuitry and second weight operation circuitry, and
   wherein the storage circuitry comprises first storage circuitry electrically connected to the first weight operation circuitry, second storage circuitry electrically connected to the second weight operation circuitry, and third storage circuitry electrically connected to the bias operation circuitry.
Embodiment 3. The device of embodiment 1, wherein the weight operation circuitry comprises first weight operation circuitry and second weight operation circuitry, and
   wherein the storage circuitry is electrically connected to the first weight operation circuitry, the second weight operation circuitry, and the bias operation circuitry.
Embodiment 4. The device of embodiment 1, wherein the storage circuitry comprises one or more storage bits.
Embodiment 5. The device of embodiment 4, wherein the one or more storage bits each comprise one or more resistive elements and a voltage amplifier.
Embodiment 6. The device of embodiment 5, wherein the one or more resistive elements comprise at least four resistive elements, wherein at least two first resistive elements are electrically connected in series and at least two second resistive elements are electrically connected in series, wherein the at least two first resistive elements are electrically connected in parallel to the at least two second resistive elements, and
   wherein an input of the voltage amplifier is electrically connected to a first electrode between the at least two first resistive elements and connected to a second electrode between the at least two second resistive elements.
Embodiment 7. The device of embodiment 5, wherein each of the one or more resistive elements comprise a magnetic tunnel junction (MTJ).
Embodiment 8. The device of embodiment 4, wherein the one or more storage bits are included in a single array of bits.
Embodiment 9. The device of embodiment 1, wherein the device comprises a hardware neuron in an artificial neural network.
Embodiment 10. The device of embodiment 1, further comprising output circuitry electrically connected to the activation function circuitry.
Embodiment 11. The device of embodiment 4, wherein each of the one or more storage bits comprises:
   a first set of resistive elements and a second set of resistive elements,
   first read circuitry electrically connected to the first set of resistive elements and second read circuitry electrically connected to the second set of resistive elements,
   cross-coupled inverter circuitry electrically connected to the first read circuitry and the second read circuitry, and
   third read circuitry electrically connected to the cross-coupled inverter circuitry.
Embodiment 12. A neuron device of an artificial neural network, comprising:
   input circuitry;
   weight operation circuitry electrically connected to the input circuitry;
   bias operation circuitry electrically connected to the weight operation circuitry;
   storage circuitry electrically connected to the weight operation circuitry and the bias operation circuitry; and
   activation function circuitry electrically connected to the bias operation circuitry,
      wherein at least the weight operation circuitry, the bias operation circuitry, and the storage circuitry are located on a same chip.
Embodiment 13. The neuron device of embodiment 12, wherein the weight operation circuitry comprises first weight operation circuitry and second weight operation circuitry, and
   wherein the storage circuitry comprises first storage circuitry electrically connected to the first weight operation circuitry, second storage circuitry electrically connected to the second weight operation circuitry, and third storage circuitry electrically connected to the bias operation circuitry.
Embodiment 14. The neuron device of embodiment 12, wherein the weight operation circuitry comprises first weight operation circuitry and second weight operation circuitry, and
   wherein the storage circuitry is electrically connected to the first weight operation circuitry, the second weight operation circuitry, and the bias operation circuitry.
Embodiment 15. The neuron device of embodiment 12, wherein the storage circuitry comprises one or more storage bits, wherein each of the one or more storage bits comprises one or more resistive elements and a voltage amplifier.
Embodiment 16. The neuron device of embodiment 15, wherein the one or more resistive elements comprise at least four resistive elements, wherein at least two first resistive elements are electrically connected in series and at least two second resistive elements are electrically connected in series, wherein the at least two first resistive elements are electrically connected in parallel to the at least two second resistive elements, and
   wherein an input of the voltage amplifier is electrically connected to a first electrode between the at least two first resistive elements and to a second electrode between the at least two second resistive elements.
Embodiment 17. The neuron device of embodiment 15, wherein the one or more storage bits are included a single array of bits.
Embodiment 18. The neuron device of embodiment 12, further comprising output circuitry electrically connected to the activation function circuitry.
Embodiment 19. The neuron device of embodiment 15, wherein each of the one or more storage bits comprises:
   a first set of resistive elements and a second set of resistive elements,
   first read circuitry electrically connected to the first set of resistive elements and second read circuitry electrically connected to the second set of resistive elements,
   cross-coupled inverter circuitry electrically connected to the first read circuitry and the second read circuitry, and
   third read circuitry electrically connected to the cross-coupled inverter circuitry.
Embodiment 20. A method of operating a device of an artificial neural network, the method comprising:
   receiving, at weight operation circuitry of the device, a value via input circuitry of the device;
   applying, at the weight operation circuitry, a weight value from storage circuitry of the device to the value to form a weighted value;
   providing the weighted value to bias operation circuitry of the device;
   applying, at the bias operation circuitry, a bias value from the storage circuitry to the weighted value to form a biased weighted value; and
   providing the biased weighted value to activation function circuitry of the device,
      wherein at least the weight operation circuitry, the bias operation circuitry, and the storage circuitry are located on a same chip.

## Claims

1. A device, comprising:
input circuitry;
weight operation circuitry electrically connected to the input circuitry;
bias operation circuitry electrically connected to the weight operation circuitry;
storage circuitry electrically connected to the weight operation circuitry and the bias operation circuitry; and
activation function circuitry electrically connected to the bias operation circuitry,
wherein at least the weight operation circuitry, the bias operation circuitry, and the storage circuitry are located on a same chip.

2. The device of claim 1, wherein the weight operation circuitry comprises first weight operation circuitry and second weight operation circuitry, and
wherein the storage circuitry comprises first storage circuitry electrically connected to the first weight operation circuitry, second storage circuitry electrically connected to the second weight operation circuitry, and third storage circuitry electrically connected to the bias operation circuitry; and/orwherein the storage circuitry is electrically connected to the first weight operation circuitry, the second weight operation circuitry, and the bias operation circuitry.

3. The device of any one of claims 1 and 2, wherein the storage circuitry comprises one or more storage bits.

4. The device of claim 3, wherein the one or more storage bits each comprise one or more resistive elements and a voltage amplifier.

5. The device of claim 4, wherein the one or more resistive elements comprise at least four resistive elements, wherein at least two first resistive elements are electrically connected in series and at least two second resistive elements are electrically connected in series, wherein the at least two first resistive elements are electrically connected in parallel to the at least two second resistive elements, and
wherein an input of the voltage amplifier is electrically connected to a first electrode between the at least two first resistive elements and connected to a second electrode between the at least two second resistive elements; or
wherein each of the one or more resistive elements comprise a magnetic tunnel junction (MTJ).

6. The device of any one of claims 3 to 5, wherein the one or more storage bits are included in a single array of bits.

7. The device of claim 1, wherein the device comprises a hardware neuron in an artificial neural network; and/or further comprising output circuitry electrically connected to the activation function circuitry.

8. The device of any one of claims 3 to 6, wherein each of the one or more storage bits comprises:
a first set of resistive elements and a second set of resistive elements,
first read circuitry electrically connected to the first set of resistive elements and second read circuitry electrically connected to the second set of resistive elements,
cross-coupled inverter circuitry electrically connected to the first read circuitry and the second read circuitry, and
third read circuitry electrically connected to the cross-coupled inverter circuitry.

9. A neuron device of an artificial neural network, comprising:
input circuitry;
weight operation circuitry electrically connected to the input circuitry;
bias operation circuitry electrically connected to the weight operation circuitry;
storage circuitry electrically connected to the weight operation circuitry and the bias operation circuitry; and
activation function circuitry electrically connected to the bias operation circuitry,
wherein at least the weight operation circuitry, the bias operation circuitry, and the storage circuitry are located on a same chip.

10. The neuron device of claim 9, wherein the weight operation circuitry comprises first weight operation circuitry and second weight operation circuitry, and
wherein the storage circuitry comprises first storage circuitry electrically connected to the first weight operation circuitry, second storage circuitry electrically connected to the second weight operation circuitry, and third storage circuitry electrically connected to the bias operation circuitry; and/or
wherein the storage circuitry is electrically connected to the first weight operation circuitry, the second weight operation circuitry, and the bias operation circuitry.

11. The neuron device of any one of claims 9 and 10, wherein the storage circuitry comprises one or more storage bits, wherein each of the one or more storage bits comprises one or more resistive elements and a voltage amplifier.

12. The neuron device of claim 11, wherein the one or more resistive elements comprise at least four resistive elements, wherein at least two first resistive elements are electrically connected in series and at least two second resistive elements are electrically connected in series, wherein the at least two first resistive elements are electrically connected in parallel to the at least two second resistive elements, and
wherein an input of the voltage amplifier is electrically connected to a first electrode between the at least two first resistive elements and to a second electrode between the at least two second resistive elements; or wherein the one or more storage bits are included a single array of bits.

13. The neuron device of any one of claims 9 to 12, further comprising output circuitry electrically connected to the activation function circuitry.

14. The neuron device of any one of claims 11 and 12, wherein each of the one or more storage bits comprises:
a first set of resistive elements and a second set of resistive elements,
first read circuitry electrically connected to the first set of resistive elements and second read circuitry electrically connected to the second set of resistive elements,
cross-coupled inverter circuitry electrically connected to the first read circuitry and the second read circuitry, and
third read circuitry electrically connected to the cross-coupled inverter circuitry.

15. A method of operating a device of an artificial neural network, the method comprising:
receiving, at weight operation circuitry of the device, a value via input circuitry of the device;
applying, at the weight operation circuitry, a weight value from storage circuitry of the device to the value to form a weighted value;
providing the weighted value to bias operation circuitry of the device;
applying, at the bias operation circuitry, a bias value from the storage circuitry to the weighted value to form a biased weighted value; and
providing the biased weighted value to activation function circuitry of the device,
wherein at least the weight operation circuitry, the bias operation circuitry, and the storage circuitry are located on a same chip.
